# DEMANDE DE BREVET EUROPEEN

(11) **EP 3 651 214 A1**
(43) Date de publication de la demande: **13.05.2020**
(21) Numéro de dépôt: 19207137.1
(22) Date de dépôt: 05.11.2019
(51) Int. Cl.: H01L 31/105, G02B 6/12, H01L 31/18

(54) **PROCÉDÉ DE RÉALISATION D'UNE PHOTODIODE ET PHOTODIODE**

(30) Priorité: 07.11.2018 FR 1860256
(71) Demandeur: Commissariat à l'Energie Atomique et aux Energies Alternatives, 75015 Paris (FR)
(72) Inventeur: EL ZAMMAR, Georgio, 38054 Grenoble Cedex 09 (FR); KHAZAKA, Rami, 38054 Grenoble Cedex 09 (FR); MENEZO, Sylvie, 38054 Grenoble Cedex 09 (FR); REBOUD, Vincent, 38054 Grenoble Cedex 09 (FR)
(74) Mandataire: Decobert, Jean-Pascal

(57) **Abrégé**

L'invention a pour objet un procédé de réalisation d'une photodiode comprenant une zone d'absorption A en Ge intercalée entre deux zones de contact 1, 2. La zone d'absorption A est formée directement sur une couche 12 d'oxyde de silicium par une première croissance épitaxiale latérale suivie d'une deuxième croissance épitaxiale verticale. Avantageusement, une cavité est formée entre les zones de contact par encapsulation et gravure, de façon à guider la première croissance latérale de Ge. Cette première croissance forme une couche de base présentant un taux de défauts structuraux réduit.

La deuxième croissance de Ge se fait ensuite à partir de cette couche de base, pour obtenir une couche de structure présentant une épaisseur plus importante tout en conservant un taux de défauts structuraux réduit.

La zone d'absorption A est avantageusement formée dans l'empilement des couches de base et de structure, de façon à obtenir une photodiode latérale GeOl.

## Description

### DOMAINE TECHNIQUE DE L'INVENTION

L'invention concerne le domaine de la photonique et de l'optoélectronique. Elle trouve au moins une application particulièrement avantageuse dans le domaine des photodétecteurs. Elle trouvera pour application avantageuse mais non limitative la réalisation de photodiodes, en particulier à base de germanium.

### ÉTAT DE LA TECHNIQUE

Dans le domaine de la photonique sur silicium, un photodétecteur est un composant optoélectronique essentiel des systèmes de communication optiques intégrables en technologie CMOS.

Un enjeu lié à la fabrication des photodétecteurs est d'augmenter la sensibilité de détection de la lumière.

Un principe de détection de la lumière dans un photodétecteur ou une photodiode est le suivant :
Un photon est absorbé dans la zone d'absorption de la photodiode. L'absorption de ce photon génère une paire électron-trou. L'électron et le trou, appelés porteurs de charge électrique, peuvent être ensuite collectés via des électrodes ou des zones de contact. Le courant électrique généré par ces porteurs peut ainsi être exploité pour la détection du photon à l'origine du phénomène.

Une architecture de photodiode exploitant ce principe est une photodiode p-i-n comprenant une zone d'absorption en un matériau non dopé (i pour intrinsèque) intercalée entre deux zones de contact en un matériau dopé (p et n pour le type de dopage correspondant).

Du fait de ses propriétés d'absorption et de conduction, et de sa compatibilité avec les technologies CMOS, le germanium (Ge) est généralement utilisé pour fabriquer des photodiodes Ge présentant une architecture classique Ge-p / Ge-i / Ge-n.

Une possibilité particulièrement intéressante pour augmenter la sensibilité de détection des photodiodes est d'améliorer le confinement des photons dans la zone d'absorption de la photodiode.

Le confinement des photons dans la zone d'absorption peut résulter d'un contraste d'indices optiques entre le matériau de la zone d'absorption et les matériaux environnants.

Le document « Développement de photodiodes à avalanche en Ge sur Si pour la détection faible signal et grande vitesse, L. Virot, Université Paris Sud - Paris XI, 2014 » divulgue par exemple une architecture latérale de photodiode p-i-n utilisant le silicium (Si) et le germanium (Ge).

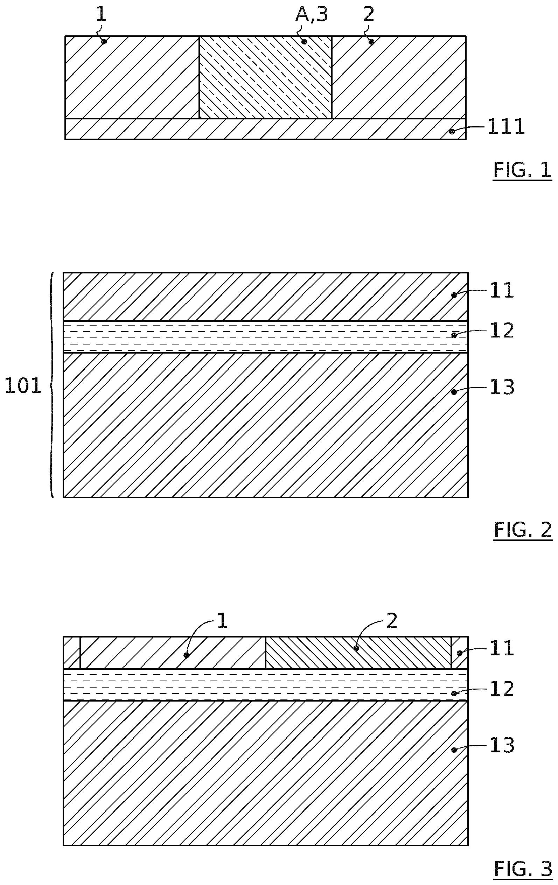

Une telle photodiode illustrée à la figure 1 présente une double hétérojonction Si-p / Ge-i / Si-n. Cette architecture permet un confinement de la lumière amélioré par rapport à une photodiode Ge classique.

La zone d'absorption A intercalée entre les zones de contact 1 et 2 de cette photodiode à double hétérojonction est formée par croissance du Ge 3 à partir d'une couche de germination 111 en Si.

Ce procédé de fabrication induit des pertes optiques au niveau de la couche de germination 111 qui nuisent au confinement optique dans la zone d'absorption A.

Par ailleurs, une zone de dislocations est présente à l'interface Si/Ge entre la couche de germination 111 et la zone d'absorption A.

Les dislocations traversantes, c'est-à-dire se propageant selon la troisième direction, génèrent un courant d'obscurité limitant les performances de détection à basse tension de la photodiode.

L'intégration d'une telle photodiode par un procédé de report sur un autre substrat est également difficile à mettre en oeuvre. L'intégration d'une telle photodiode avec d'autres composants est limitée.

Un objet de la présente invention est de pallier au moins en partie certains des inconvénients mentionnés ci-dessus.

Selon un aspect particulier, un objet de la présente invention est de proposer un procédé de réalisation d'une photodiode latérale visant à optimiser le confinement optique dans la zone d'absorption de la photodiode.

Selon un autre aspect, un objet de la présente invention est de proposer un procédé de réalisation d'une photodiode latérale visant à réduire le taux de dislocations traversantes dans la zone d'absorption de la photodiode.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un premier aspect de l'invention concerne un procédé de réalisation d'une photodiode comprenant une première zone de contact, une deuxième zone de contact et une zone d'absorption juxtaposées de sorte à s'étendre parallèlement suivant une première direction, ladite zone d'absorption étant située entre les première et deuxième zones de contact selon une deuxième direction.

Ce procédé comprend les étapes suivantes :
- Fournir un premier substrat comprenant un empilement selon une troisième direction d'une première couche à base d'un premier matériau sur une deuxième couche à base d'un deuxième matériau différant du premier matériau,
- Former au niveau de la première couche la première zone de contact,
- Former au niveau de la première couche la deuxième zone de contact,
- Former au niveau de la première couche la zone d'absorption.

Avantageusement mais non limitativement, la formation de la zone d'absorption comprend au moins une première croissance d'une couche de base, dite croissance latérale, suivie d'au moins une deuxième croissance d'une couche de structure, dite croissance verticale.

La première croissance comprend au moins les étapes successives suivantes :
- Retirer le premier matériau dans la zone d'absorption sur toute l'épaisseur de la première couche de façon à exposer une face inférieure à base du deuxième matériau, et au moins une face à base du premier matériau sensiblement normale au plan basal, dite face latérale, présentant un bord au contact de ladite face inférieure exposée,
- Former la couche de base en un troisième matériau par croissance épitaxiale dudit troisième matériau à partir de l'au moins une face latérale, ladite croissance étant principalement dirigée selon la deuxième direction et au moins partiellement guidée par au moins une paroi parallèle au plan basal, de sorte que la couche de base couvre toute la face inférieure.
la deuxième croissance comprenant les étapes successives suivantes :
- Exposer une face supérieure de la couche de base parallèle au plan basal,
- Former la couche de structure en un quatrième matériau par croissance épitaxiale dudit quatrième matériau selon la troisième direction à partir de la face supérieure de la couche de base.

Ce procédé permet d'obtenir un empilement de couches, comprenant la couche de base et la couche de structure, directement au contact du deuxième matériau.

La croissance épitaxiale selon la deuxième direction permettant de former la couche de base est dite croissance épitaxiale latérale.

La croissance épitaxiale selon la troisième direction permettant de former la couche de structure est dite croissance épitaxiale verticale.

La croissance épitaxiale latérale sur toute la face inférieure à base du deuxième matériau permet avantageusement de s'affranchir d'une couche de germination sur ladite face inférieure, pour la croissance du troisième matériau.

La couche de base issue de cette croissance épitaxiale latérale est de préférence de faible épaisseur, par exemple comprise entre 10 nm et 50 nm, de façon à réduire le taux de dislocations de cette couche de base, c'est-à-dire de façon à optimiser la qualité cristalline de cette couche de base.

Selon une possibilité, le quatrième matériau est à base du troisième matériau ou identique au troisième matériau.

Dès lors, la croissance épitaxiale verticale du quatrième matériau sur la face supérieure de la couche de base permet d'obtenir une couche de structure présentant une épaisseur de matériau à base du troisième matériau plus importante, tout en conservant une qualité cristalline optimale pour la couche de structure. La croissance épitaxiale verticale donc peut se faire par homoépitaxie.

La croissance épitaxiale verticale se fait pour un quatrième matériau présentant un désaccord de maille avec le troisième matériau de préférence inférieur à 0.2%.

Le taux de dislocations traversantes est ainsi réduit à la fois dans la couche de base et dans la couche de structure.

Avantageusement, la zone d'absorption est formée dans l'empilement des couches de base et de structure, de préférence sur toute la hauteur de l'empilement.

La zone d'absorption est ainsi formée directement sur la deuxième couche du substrat, sans recourir à une couche de germination intercalaire.

Le confinement optique dans la zone d'absorption de la photodiode peut ainsi être amélioré en supprimant les pertes optiques induites par la couche de germination.

Par ailleurs, la qualité cristalline de la zone d'absorption est optimisée. La réduction du taux de dislocations, en particulier de dislocations traversantes, dans la zone d'absorption permet *in fine* de réduire le courant d'obscurité à basse tension des photodiodes.

Selon une possibilité préférée, le troisième matériau est à base de germanium (Ge), par exemple en germanium ou en un alliage germanium-étain (GeSn). Le quatrième matériau peut être du germanium, du germanium-étain, de l'arsénure de gallium, du phosphorure d'indium par exemple.

Le procédé selon l'invention permet dès lors d'obtenir un empilement local de type GeOI (selon l'acronyme anglais « Germanium On Insulator»).

Le contraste d'indices optiques est ainsi optimisé et le confinement des photons dans la zone d'absorption selon la troisième direction est amélioré.

En outre, la disposition relative des zones de contact et d'absorption confère à la photodiode une architecture dite latérale.

Le procédé selon l'invention permet donc d'obtenir des photodiodes latérales p-in GeOI, par exemple une photodiode p-i-n à double hétérojonction Si-Ge-Si, présentant une qualité cristalline optimisée.

De telles photodiodes constituent également un aspect séparable de l'invention.

Selon un mode de réalisation préféré de l'invention, la couche de base est crue au sein d'une cavité préalablement formée.

En particulier, cette cavité comprend l'au moins une face latérale, une paroi inférieure et une paroi supérieure. Les parois inférieure et supérieure sont à base d'un matériau diélectrique pris parmi un oxyde de silicium et un nitrure de silicium. La croissance épitaxiale latérale principalement selon la deuxième direction est dès lors contrainte selon la première direction. La formation de la couche de base est ainsi mieux contrôlée, et sa qualité cristalline améliorée.

La photodiode réalisée par le procédé selon l'invention pourra avantageusement équiper un photodétecteur dans le domaine de la photonique sur silicium.

Un deuxième aspect séparable de l'invention concerne une photodiode comprenant une première zone de contact, une deuxième zone de contact et une zone d'absorption formées dans une première couche à base d'un premier matériau et juxtaposées de sorte à s'étendre parallèlement suivant une première direction, ladite zone d'absorption étant située entre les première et deuxième zones de contact selon une deuxième direction, la première couche étant au contact d'une deuxième couche à base d'un deuxième matériau différant du premier matériau, selon une troisième direction perpendiculaire aux première et deuxième directions.

Avantageusement, la zone d'absorption est formée directement au contact du deuxième matériau de la deuxième couche suivant une épaisseur de la première couche, préférentiellement sur toute une épaisseur de la première couche, et comprend au moins un troisième matériau différant des premier et deuxième matériaux.

Avantageusement, l'une au moins parmi les première et deuxième zones de contact présente une marche en regard de l'autre parmi les première et deuxième zones de contact, ladite marche prenant appui sur la deuxième couche et étant située entre la première couche et la zone d'absorption.

Une telle photodiode latérale permet d'optimiser le confinement optique dans la zone d'absorption de la photodiode.

En particulier, le contraste d'indice entre le deuxième matériau et l'au moins un troisième matériau peut être avantageusement plus grand que le contraste d'indice entre le premier matériau et l'au moins un troisième matériau.

Selon une possibilité, le premier matériau est du silicium ou du germanium, le deuxième matériau est un matériau diélectrique tel qu'un oxyde de silicium, et l'au moins un troisième matériau est du germanium ou un alliage de germanium-étain ou un alliage de silicium-germanium-étain.

La photodiode selon l'invention peut donc être avantageusement une photodiode latérale GeOI dans laquelle la zone d'absorption en Ge est directement au contact de l'oxyde de silicium de la deuxième couche sous-jacente. La photodiode selon l'invention peut ausii être une photodiode latérale p-i-n à double hétérojonction Ge-GeSn-Ge dans laquelle la zone d'absorption en GeSn est directement au contact de l'oxyde de silicium de la deuxième couche sous-jacente.

La marche peut avantageusement former un germe pour une croissance épitaxiale latérale du troisième matériau selon la deuxième direction. Une telle croissance permet de former une couche de base en ce troisième matériau présentant un taux de dislocations réduit.

Cette marche présente de préférence une épaisseur inférieure à l'épaisseur de la première couche, et de préférence comprise entre 10 nm et 50 nm.

Dès lors, la zone d'absorption s'étendant sur toute l'épaisseur de la première couche comprend la couche de base et au moins une couche de structure en un quatrième matériau, ou à base du troisième matériau, sur ladite couche de base de manière à obtenir l'épaisseur souhaitée.

Une couche de structure à base du troisième matériau peut être avantageusement réalisée par homoépitaxie du troisième matériau sur la couche de base, selon la troisième direction. Cela permet de former une couche de structure en ce troisième matériau présentant un taux de dislocations réduit.

Une telle photodiode comprend donc avantageusement une zone d'absorption présentant à la fois un taux de dislocations réduit et une épaisseur importante du troisième matériau, par exemple sur toute l'épaisseur de la première couche.

La photodiode selon l'invention peut être réalisée par le procédé selon le premier aspect de l'invention.

La photodiode selon l'invention pourra avantageusement équiper un photodétecteur dans le domaine de la photonique sur silicium.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
- La FIGURE 1 est une vue en coupe d'une photodiode latérale à double hétérojonction selon l'art antérieur ;
- Les FIGURES 2 à 13B illustrent des étapes de réalisation d'une photodiode selon un premier mode de réalisation de la présente invention ;
- Les FIGURES 14 à 16 illustrent des étapes de réalisation d'une photodiode selon un deuxième mode de réalisation de la présente invention ;
- La FIGURE 17 montre une vue par microscopie électronique en transmission à haute résolution (HRTEM) en coupe transverse d'une couche de base en Ge selon un mode de réalisation de la présente invention.

Les figures portant le même numéro indexées A et B illustrent une même étape de procédé respectivement en coupe transverse et en vue de dessus.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs et dimensions des différentes couches et portions des photodiodes illustrées ne sont pas représentatives de la réalité.

### DESCRIPTION DÉTAILLÉE DE L'INVENTION

Avant d'entamer une revue détaillée de modes de réalisation de l'invention, il est rappelé que l'invention selon son premier aspect comprend éventuellement notamment les caractéristiques optionnelles ci-après pouvant être utilisées en association ou alternativement :
- La première croissance comprend les sous-étapes suivantes pour retirer le premier matériau sur toute l'épaisseur de la première couche :
   ∘ Retirer le premier matériau de la première couche en conservant une couche sacrificielle à base du premier matériau sur la deuxième couche, ladite couche sacrificielle présentant une épaisseur résiduelle e selon la troisième direction et une largeur w selon la deuxième direction,
   ∘ Encapsuler la couche sacrificielle par une couche d'encapsulation en un matériau d'encapsulation différant du premier matériau,
   ∘ Former au moins une ouverture au travers de la couche d'encapsulation de sorte à exposer une zone de la couche sacrificielle,
   ∘ Former une cavité de largeur ws telle que ws ≤ w en retirant le premier matériau sur toute l'épaisseur résiduelle de la couche sacrificielle (30) au travers de l'au moins une ouverture, de façon à exposer la face inférieure à base du deuxième matériau, l'au moins une face latérale et une face de la couche d'encapsulation, la cavité comprenant ladite au moins une face latérale, une paroi inférieure formée par ladite face inférieure et une paroi supérieure parallèle au plan basal et à base du matériau d'encapsulation formée par ladite face de la couche d'encapsulation,
   de sorte que la croissance épitaxiale permettant de former la couche de base soit au moins partiellement guidée par lesdites parois inférieure et supérieure, la couche de base présentant une épaisseur égale à l'épaisseur résiduelle e.
   - La formation de l'au moins une ouverture est configurée de sorte à ce que la zone exposée de la couche sacrificielle soit située en dehors de la zone d'absorption, de préférence à une distance supérieure à 1 µm de la zone d'absorption.
- la deuxième croissance comprend en outre, avant formation de la couche de structure, l'étape suivante :
   ∘ Former au moins une couche latérale présentant des parois latérales sensiblement normales au plan basal en un matériau différant du premier matériau, ladite au moins une couche latérale prenant appui sur une face parallèle au plan basal comprenant la face supérieure de la couche de base,
   de sorte que la croissance épitaxiale permettant de former la couche de structure soit au moins partiellement guidée par lesdites parois latérales.
- la deuxième croissance comprend les sous-étapes suivantes pour former l'au moins une couche latérale :
   ∘ Retirer partiellement la couche d'encapsulation de façon à exposer la face parallèle au plan basal comprenant la face supérieure de la couche de base, en laissant une partie du matériau d'encapsulation de façon à former l'au moins une couche latérale.
- la deuxième croissance comprend les sous-étapes suivantes pour former l'au moins une couche latérale :
   ∘ Retirer totalement la couche d'encapsulation de façon à exposer la face parallèle au plan basal comprenant la face supérieure de la couche de base,
   ∘ Former l'au moins une couche latérale en un matériau pris parmi un oxyde de silicium et un nitrure de silicium.
      - Les premier, troisième et quatrième matériaux présentent chacun une structure cristallographique de type cubique, et la première direction correspond à une orientation cristallographique de type [100], la deuxième direction correspond à une orientation cristallographique de type [010], et la troisième direction correspond à une orientation cristallographique de type [001].
      - Le retrait du premier matériau lors de la formation de la cavité se fait par gravure, ladite gravure étant configurée pour produire une vitesse de gravure au moins 25 % plus grande dans des directions cristallographiques [110] et [1-10] que dans des directions cristallographiques [010] et [100] du premier matériau de la première couche, et de préférence au moins 35 % plus grande.
- La largeur ws de la cavité est strictement inférieure à la largeur w de la couche sacrificielle, de préférence w - ws ≥ 125 nm, de sorte que la couche sacrificielle forme au moins une marche entre la deuxième couche et la première couche.
- L'au moins une couche latérale comprend une première couche latérale au contact d'au moins une face de la première zone de contact sensiblement normale à la deuxième direction, ladite première couche latérale présentant une largeur w1 selon la deuxième direction supérieure ou égale à 10 nm et/ou inférieure ou égale à 100 nm.
- L'au moins une couche latérale comprend une deuxième couche latérale au contact d'au moins une face de la deuxième zone de contact sensiblement normale à la deuxième direction, ladite deuxième couche latérale présentant une largeur w2 selon la deuxième direction supérieure ou égale à 10 nm et/ou inférieure ou égale à 100 nm.
- La couche de base présente une épaisseur e selon la troisième direction supérieure ou égale à 10 nm et/ou inférieure ou égale à 50 nm.
   - Le premier substrat comprend une troisième couche, de sorte que la deuxième couche soit intercalée entre les première et troisième couches selon la troisième direction, le procédé comprenant en outre une séquence d'étapes de retournement de la photodiode sur un deuxième substrat, ladite séquence comprenant les étapes suivantes :
      - Fournir un deuxième substrat,
      - Coller par adhésion moléculaire le deuxième substrat au premier substrat selon la troisième direction, la première couche du premier substrat étant tournée en regard du deuxième substrat,
      - Retirer la troisième couche du premier substrat.
   - Le procédé comprend en outre une formation au niveau de la première couche d'un guide d'onde en couplage direct avec la zone d'absorption.
   - L'au moins une ouverture présente un contour fermé et est distante de la première zone de contact d'une distance d selon la deuxième direction telle que 0.6 µm < d < 1.5 µm et de préférence 1.1 µm < d < 1.5 µm.
   - L'au moins une face latérale à base du premier matériau comprend une première face latérale et une deuxième face latérale en regard de la première face latérale, et l'au moins une ouverture est située à égale distance desdites première et deuxième faces latérales selon la deuxième direction.
- La croissance épitaxiale permettant de former la couche de base se fait à une première température T1 comprise entre 300°C < T1 < 450°C.
- La croissance épitaxiale permettant de former la couche de structure se fait à une deuxième température T2 comprise entre 300°C et 750°C.
   - Le premier matériau est du silicium ou du germanium, le deuxième matériau est un matériau diélectrique tel qu'un oxyde de silicium, le troisième matériau est pris parmi du germanium ou un alliage de germanium-étain, et le quatrième matériau est pris parmi du germanium, du germanium-étain, de l'arsénure de gallium, du phosphorure d'indium.
   - La formation d'au moins une parmi les première et deuxième zones de contact se fait par implantation ionique préalablement à la formation de la zone d'absorption.

L'invention selon son deuxième aspect comprend éventuellement notamment les caractéristiques optionnelles ci-après pouvant être utilisées en association ou alternativement :
- Les premier, deuxième et troisième matériaux présentent respectivement des premier, deuxième et troisième indices de réfraction n1, n2, n3 tels que n2 < n1 < n3 et de préférence n2 ≤ 2, n1 ≥ 3 et n3 ≥ 3.5.
- La marche présente une épaisseur e selon la troisième direction supérieure ou égale à 10 nm et/ou inférieure ou égale à 50 nm.
- La marche présente une largeur wi selon la deuxième direction supérieure ou égale à 10 nm et/ou inférieure ou égale à 100 nm.
- La marche présente une épaisseur inférieure à celle de la zone d'absorption.
- La marche présente une épaisseur inférieure à celle d'une portion principale de l'une au moins parmi les première et deuxième zones de contact portant la marche.
- La photodiode comprend en outre au moins une couche latérale prenant appui sur la marche et située entre la première couche et la zone d'absorption, ladite au moins une couche latérale étant en un matériau pris parmi un oxyde de silicium et un nitrure de silicium.
- Le premier matériau est du silicium ou du germanium, le deuxième matériau est un matériau diélectrique tel qu'un oxyde de silicium, et l'au moins un troisième matériau est du germanium ou un alliage de germanium-étain.
- Le contraste d'indice entre le deuxième matériau et l'au moins un troisième matériau est supérieur au contraste d'indice entre le premier matériau et l'au moins un troisième matériau.

Dans la suite, une zone d'absorption est une zone configurée pour absorber en partie au moins les photons d'un flux lumineux incident et générer en réponse des porteurs de charges électriques, ladite génération de charges résultant du phénomène d'absorption. La zone d'absorption est de préférence en germanium ou en alliage de germanium-étain dans la présente demande.

Il est précisé que, dans le cadre de la présente invention, la disposition relative d'une troisième zone intercalée entre une première zone et une deuxième zone, ne signifie pas obligatoirement que les zones sont directement au contact les unes des autres, mais signifie que la première zone est soit directement au contact des première et deuxième zones, soit séparée de celles-ci par au moins une autre zone ou au moins un autre élément.

Les étapes de formation des zones, notamment celles de contact et celle d'absorption s'entendent au sens large : elles peuvent être réalisées en plusieurs sous-étapes qui ne sont pas forcément strictement successives.

Dans la présente invention des types de dopage sont indiqués. Ces dopages sont des exemples non limitatifs. L'invention couvre tous les modes de réalisation dans lesquels les dopages sont inversés. Ainsi, si un exemple de réalisation mentionne pour une première zone un dopage p et pour une deuxième zone un dopage n, la présente description décrit alors, implicitement au moins, l'exemple inverse dans lequel la première zone présente un dopage n et la deuxième zone un dopage p.

Les gammes de dopage associées aux différents types de dopage indiqués dans la présente demande sont les suivantes :
- dopage p++ ou n++ : supérieur à 1 x 10²⁰cm⁻³
- dopage p+ ou n+ : 1 x 10¹⁸ cm⁻³ à 9 x 10¹⁹ cm⁻³
- dopage p ou n : 1 x 10¹⁷ cm⁻³ à 1 x 10¹⁸ cm⁻³
- dopage intrinsèque : 1.10¹⁵ cm⁻³ à 1.10¹⁷ cm⁻³

Dans la suite, les abréviations suivantes relatives à un matériau M sont éventuellement utilisées :
M-i réfère au matériau M intrinsèque ou non intentionnellement dopé, selon la terminologie habituellement utilisée dans le domaine de la microélectronique pour le suffixe -i.
M-n réfère au matériau M dopé n, n+ ou n++, selon la terminologie habituellement utilisée dans le domaine de la microélectronique pour le suffixe -n.
M-p réfère au matériau M dopé p, p+ ou p++, selon la terminologie habituellement utilisée dans le domaine de la microélectronique pour le suffixe -p.

On entend par un substrat, un film, une couche, « à base » d'un matériau M, un substrat, un film, une couche comprenant ce matériau M uniquement ou ce matériau M et éventuellement d'autres matériaux, par exemple des éléments d'alliage, des impuretés ou des éléments dopants. Ainsi, une couche en un matériau à base de germanium (Ge) peut par exemple être une couche de germanium (Ge ou Ge-i) ou une couche de germanium dopé (Ge-p, Ge-n) ou encore une couche d'un alliage de germanium-étain (GeSn). Une couche en un matériau à base de silicium (Si) peut par exemple être une couche de silicium (Si ou Si-i) ou une couche de silicium dopé (Si-p, Si-n) ou encore une couche d'un alliage de silicium-germanium (SiGe).

Dans la présente demande de brevet, les première, deuxième et troisième directions correspondent respectivement aux directions portées par les axes x, y, z d'un repère de préférence orthonormé. Ce repère est représenté sur les figures annexées à la présente demande de brevet.

Dans la suite, la longueur est prise selon la première direction x, la largeur est prise selon la deuxième direction y, et l'épaisseur est prise selon la troisième direction z.

Dans la suite, les faces ou les flancs sont décrits par souci de clarté tels que s'étendant principalement selon des plans. Ces faces et ces flancs ne sont cependant pas rigoureusement compris dans lesdits plans, en tenant compte des tolérances de fabrication et/ou de mesure. Ces faces et ces flancs peuvent présenter des courbures et/ou des déviations angulaires en dehors desdits plans. La projection d'une face ou d'un flanc dans le plan correspondant présente néanmoins de préférence une surface supérieure ou égale à 80% de la surface de la face ou du flanc.

On entend par « latérale » selon les cas : une orientation des parois ou des couches normale à y, une croissance par épitaxie dirigée selon y, une disposition selon y des différentes zones actives ou éléments de la photodiode relativement les uns aux autres.

Pour déterminer la géométrie des interfaces entre les différentes couches, en particulier entre la couche sacrificielle et la couche de base, on peut procéder à des analyses de Microscopie Electronique à Balayage (MEB) ou de Microscopie Electronique en Transmission (MET ou TEM pour l'acronyme anglais de « Transmission Electron Microscopy »).

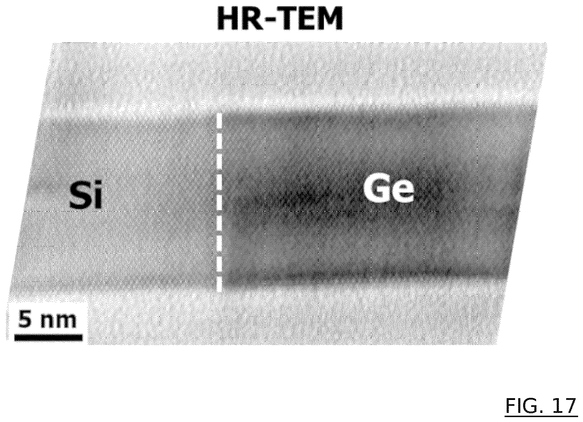

Une croissance épitaxiale d'un matériau sur un autre produit une interface bien définie et sensiblement plane entre ces matériaux. En particulier, une croissance épitaxiale latérale de Ge sur une face latérale de Si produit une interface Si-Ge plane et potentiellement sans défauts structuraux. Une telle interface Si-Ge obtenue par le procédé selon l'invention est illustrée à la figure 17 annexée à la présente demande.

Ces techniques permettent également d'observer la présence d'une marche prenant appui sur la deuxième couche et étant située entre la première couche et la zone d'absorption d'une photodiode selon l'invention.

Ces techniques permettent également d'observer la présence d'une marche prenant appui sur la deuxième couche et étant située entre la première couche et la zone d'absorption d'une photodiode selon l'invention.

Les compositions chimiques des différentes zones peuvent être déterminées à l'aide des méthodes suivantes bien connues telles que :
- EDX ou X-EDS acronyme de « energy dispersive x-ray spectroscopy » qui signifie « analyse dispersive en énergie de photons X ».
   Cette méthode est bien adaptée pour analyser la composition de dispositifs de petites tailles telles que des photodiodes comprenant des couches ou des zones de faibles épaisseurs. Elle peut être mise en oeuvre sur des coupes métallurgiques au sein d'un Microscope Electronique à Balayage (MEB) ou sur des lames minces au sein d'un Microscope Electronique en Transmission (MET).
- SIMS, acronyme de « Secondary Ion Mass Spectroscopy » qui signifie « Spectroscopie de Masse à Ionisation Secondaire ».
- ToF-SIMS, acronyme de « Time of Flight Secondary Ion Mass Spectroscopy » qui signifie « Spectroscopie de Masse à Ionisation Secondaire à temps de vol ».
   Ces méthodes permettent d'accéder à la composition élémentaire des zones.

La qualité structurale d'une couche peut être étudiée par Microscopie Electronique en Transmission (MET ou TEM pour l'acronyme anglais de « Transmission Electron Microscopy »).

Les dislocations traversantes peuvent être en particulier observées par cette technique et ses dérivées (observation en faisceau faible et/ou champ sombre par exemple).

Un premier mode de réalisation du procédé selon l'invention va maintenant être décrit en référence aux figures 2 à 13B. La photodiode obtenue par ce premier mode de réalisation est une photodiode latérale p-i-n GeOI à double hétérojonction comprenant une zone d'absorption A en Ge-i intercalée selon y entre une première zone de contact 1 en Si-n et une deuxième zone de contact 2 en Si-p.

Avantageusement, la zone d'absorption est obtenue par deux croissances épitaxiales successives. Une première croissance épitaxiale latérale de Ge permet notamment de former une couche de base. Cette première croissance épitaxiale latérale est suivie d'une deuxième croissance épitaxiale verticale de Ge de façon à former une couche de structure sur la couche de base.

Selon le premier mode de réalisation, une première étape consiste à fournir un substrat 101 (figure 2) de préférence SOI (acronyme de « Silicon On Insulator » signifiant silicium sur isolant ; mais des matériaux autres que le silicium sont aussi possibles). La première couche 11 en silicium, également dénommée top Si (signifiant silicium supérieur) dans la suite, présente de préférence une épaisseur comprise entre 100 nm et 700 nm, de préférence sensiblement égale à 300 nm. La deuxième couche 12 en dioxyde de silicium, également dénommée BOX (acronyme de « Burried Oxide » signifiant oxyde enterré) présente de préférence une épaisseur comprise entre 10 nm et 2µm, de préférence entre 10 nm et 100 nm, de préférence sensiblement égale à 20 nm. La troisième couche 13 est en silicium et peut être également dénommée Si bulk (signifiant silicium massif) dans la suite.

Ce substrat peut présenter un diamètre de 200mm ou 300mm.

L'étape suivante consiste à former au niveau de la première couche 11 les première et deuxième zones de contact 1, 2, de préférence par implantation ionique sur toute l'épaisseur du top Si 11 (figure 3). La première zone de contact 1 peut être dopée n++ (concentration de dopants supérieure à 1 x 10²⁰ cm⁻³) ou présenter une concentration de dopants supérieure à 1 x 10¹⁹ cm⁻³, par exemple comprise entre 1 à 3 x 10¹⁹ cm⁻³. Elle peut présenter une largeur de l'ordre de 15 µm ou plus.

La deuxième zone de contact 2 peut être dopée p++ (concentration de dopants supérieure à 1 x 10²⁰ cm⁻³) ou présenter une concentration de dopants supérieure à 1 x 10¹⁹ cm⁻³, par exemple comprise entre 1 à 3 x 10¹⁹ cm⁻³. Elle peut présenter une largeur de l'ordre de 15 µm ou plus.

Les première et deuxième zones de contact 1, 2 peuvent être adjacentes selon un plan zx.

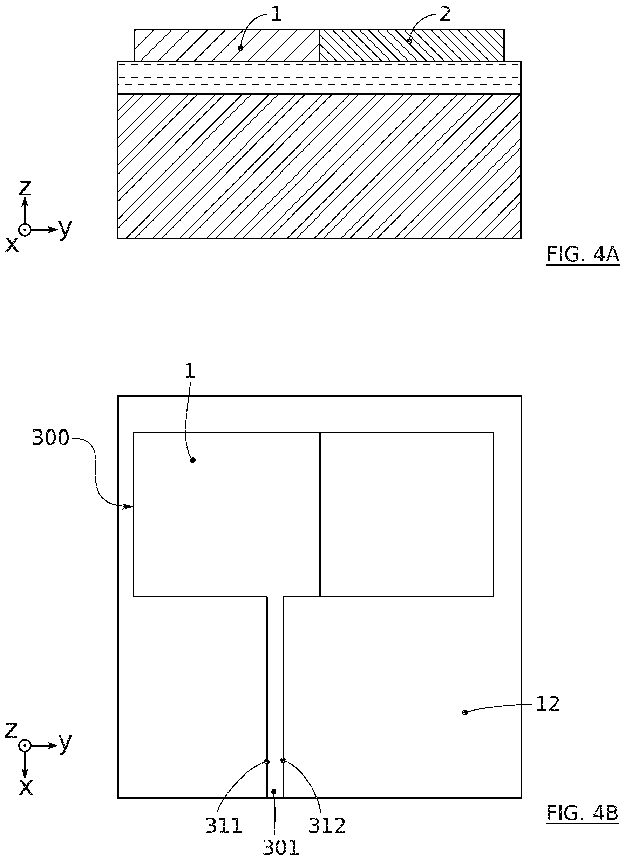

Une étape de définition d'un premier motif 300 comprenant la première zone de contact 1, la zone d'absorption A et la deuxième zone de contact 2 est de préférence effectuée par lithographie et gravure sélective du top Si sur toute sa hauteur (figure 4A). La gravure sélective du top Si 11 par rapport au BOX 12 en dioxyde de silicium est largement connue et n'est pas caractéristique de la présente invention.

La définition d'un deuxième motif en forme de guide d'onde 301 est également effectuée par lithographie et gravure sélective du top Si sur toute sa hauteur (figure 4B), de préférence lors de la définition du premier motif 300.

Ce guide d'onde 301 est de préférence configuré pour coopérer avec la zone d'absorption A par couplage direct. Le guide d'onde 301 présente de préférence une continuité avec la zone d'absorption A du premier motif 300.

Le guide d'onde 301 peut être centré ou non sur la zone d'absorption A. Il peut présenter une largeur comprise entre 300 nm et 600 nm, de préférence de l'ordre de 400 nm. Sa hauteur peut être égale à celle du top Si 11.

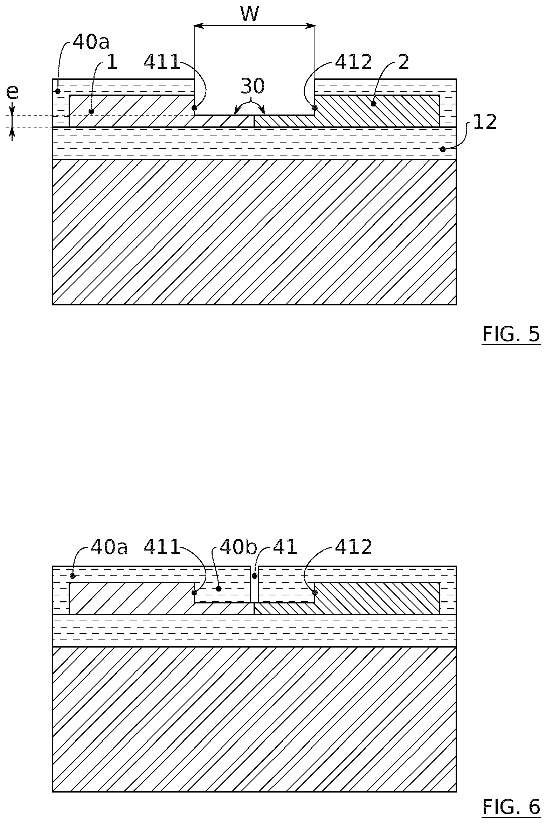

Une première étape d'encapsulation est ensuite effectuée de sorte à recouvrir les premier et deuxième motifs 300, 301 par une couche d'encapsulation 40a (figure 5).

La couche d'encapsulation 40a peut être déposée par une méthode de dépôt chimique en phase vapeur (CVD) et est de préférence conforme. La couche d'encapsulation 40a présente de préférence une épaisseur comprise entre 100nm et 300nm. Elle peut être une couche d'oxyde, par exemple une couche de dioxyde de silicium.

Après encapsulation, une première ouverture est réalisée par gravure dans la couche d'encapsulation 40a et dans le top Si 11 sur une partie de sa hauteur, dite partie supérieure.

Cette première ouverture est réalisée entre les première et deuxième zones de contact 1, 2, et aussi de préférence en partie dans les première et deuxième zones de contact 1, 2. Elle est située pour partie en sortie du guide d'onde 301.

Elle comprend des première et deuxième faces latérales 411, 412 selon zx, et une face de sortie selon zy du guide d'onde 301. Ces faces sont également dénommées simplement flancs.

Cette première ouverture présente de préférence une largeur w entre les première et deuxième faces latérales 411, 412 comprise entre 1 µm et 4 µm, par exemple de l'ordre de 3,2 µm.

Elle présente de préférence une longueur sensiblement égale ou légèrement supérieure à la longueur des première et deuxième zones de contact 1, 2, de façon à séparer lesdites première et deuxième zones de contact 1, 2 sur la partie supérieure.

En particulier, la gravure de la première ouverture et la définition du guide d'onde 301 sont de préférence configurées de manière à ce que le flanc longitudinal 311 du guide d'onde 301 soit situé à une distance selon y supérieure ou égale à 50 nm, de préférence supérieure ou égale à 60 nm, du flanc 411, afin d'améliorer le couplage entre le mode optique guidé destiné à être absorbé et la zone d'absorption.

La gravure de la première ouverture et la définition du guide d'onde 301 sont de préférence configurées de manière à ce que le flanc longitudinal 312 du guide d'onde 301 soit situé à une distance selon y supérieure ou égale à w/2 + 300 nm du flanc 412, afin d'éviter que le mode optique guidé ne soit perturbé par une zone médiane selon x entre les flancs 411, 412.

Cette première ouverture permet d'exposer une couche sacrificielle 30 au contact du BOX 12, en partie inférieure du top Si 11, sans exposer la couche sous-jacente, ici la couche BOX 12.

La gravure de la couche d'encapsulation 40a et du top Si 11 est connue en soi. Elle est configurée pour être arrêtée dans le top Si 11 de façon à former une couche sacrificielle 30 présentant une épaisseur résiduelle e de préférence inférieure ou égale à 50nm, voire à 20 nm et /ou supérieure ou égale à 10 nm(figure 5).

Cette couche sacrificielle 30 de largeur w et d'épaisseur e comprend une partie des première et deuxième zones de contact 1, 2 dans la partie inférieure. Elle assure une continuité entre les première et deuxième zones de contact 1, 2, et une continuité avec le guide d'onde 301.

Une deuxième étape d'encapsulation est réalisée de façon à couvrir le fond et les flancs à base de Si de la première ouverture par une couche d'encapsulation 40b (figure 6).

La couche d'encapsulation 40b peut être déposée par une méthode de dépôt chimique en phase vapeur (CVD) et est de préférence conforme. La couche d'encapsulation 40b peut remplir la première ouverture. Elle peut être une couche d'oxyde, par exemple une couche de dioxyde de silicium.

A l'issue de ces deux étapes d'encapsulation, un polissage mécano-chimique CMP (signifiant « Chemical-Mechanical Polishing selon l'acronyme anglais) est de préférence effectué de manière à planariser les couches d'encapsulation 40a, 40b pour obtenir une surface plane dans un plan xy. Ce polissage CMP est configuré pour laisser une épaisseur de couche d'encapsulation 40a comprise entre 50nm et 200nm, de sorte à protéger les premier et deuxième motifs 300, 301 notamment lors des étapes suivantes de gravure.

Après cette deuxième étape d'encapsulation, une ou des ouvertures 41 sont formées au travers de la couche d'encapsulation 40b selon toute son épaisseur de sorte à exposer des zones de la couche sacrificielle 30 (figure 6). Ces ouvertures 41 peuvent être formées à l'issue d'étapes classiques de lithographie/gravure. Les ouvertures 41 présentent de préférence une section circulaire ayant un diamètre compris entre 50 nm et 200 nm, de préférence de l'ordre de 100 nm. Plus généralement, la plus grande dimension en section dans le plan xy des ouvertures 41 est de préférence inférieure ou égale à 200nm et/ou supérieure ou égale à 50nm.

Ces ouvertures 41 sont de préférence situées à une distance d selon y de la première zone de contact 1 et/ou de la deuxième zone de contact 2, telle que 0.6 µm < d ≤ 1.5 µm et de préférence d ≈ 1,5 µm. Cela permet d'éloigner les ouvertures 41 de la première zone de contact 1 et/ou de la deuxième zone de contact 2. Les ouvertures constituent en effet des singularités qui peuvent engendrer certains aléas lors des étapes suivantes de procédé, en particulier lors de l'épitaxie latérale de Ge dans la cavité 42 formée par retrait au moins partiel de la couche sacrificielle 30. Dès lors, il est avantageux de former les ouvertures 41 le plus loin possible de la première zone de contact 1 et/ou de la deuxième zone de contact 2 et/ou de la zone d'absorption A, de manière à ce que le passage des charges électriques et/ou du flux lumineux ne soit pas perturbé par les singularités formées par ces ouvertures 41.

Les ouvertures 41 sont de préférence régulièrement espacées entre elles selon x, par exemple d'une distance D ≤ 2d.

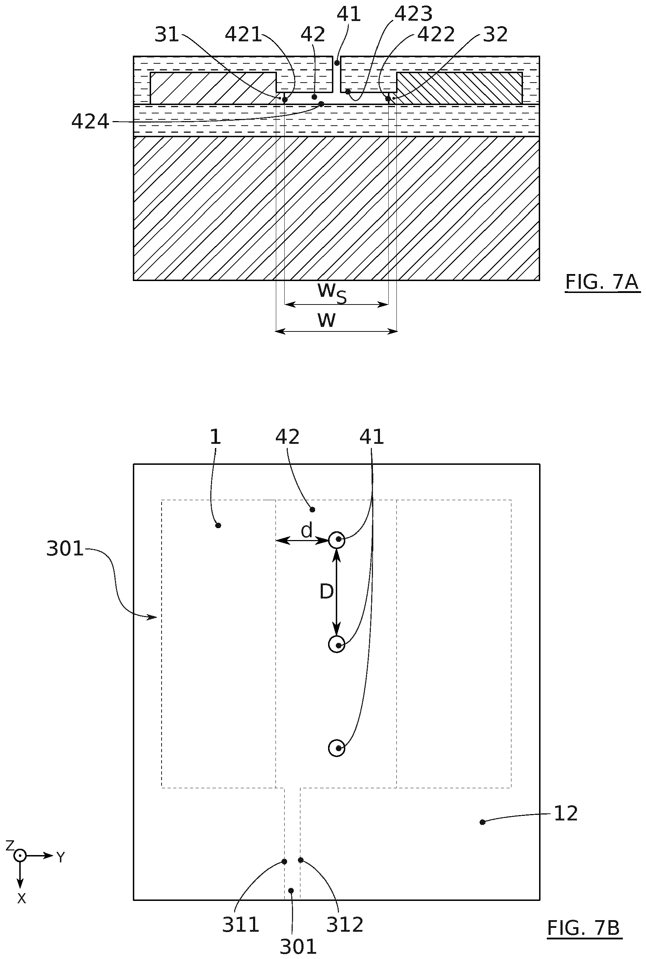

Après ouverture de la couche d'encapsulation 40b, une étape de gravure de la couche sacrificielle 30 sélectivement au dioxyde de silicium (SiO2) de la couche d'encapsulation 40b et du BOX 12 est réalisée au travers des ouvertures 41, de sorte à former des alvéoles sous-jacentes aux ouvertures 41 (figure 7A).

Une alvéole correspond à une ouverture 41 au moins au début de la gravure. Les alvéoles sont de préférence centrées sur les ouvertures 41 correspondantes.

Ces alvéoles peuvent avantageusement présenter un recouvrement entre elles selon y de sorte à former la cavité 42 en fin de gravure, tel qu'illustré en vue de dessus à la figure 7B.

Cette cavité 42 peut donc être éventuellement issue de plusieurs alvéoles agrégées selon y.

Le positionnement des ouvertures 41 est choisi de sorte à ce que la cavité 42 issue des alvéoles sous-jacentes auxdites ouvertures 41 présente de préférence une section rectangulaire dans le plan xy après gravure.

La cavité 42 comprend une paroi inférieure formée par la face inférieure 424 en SiO2 du BOX 12. Elle comprend une paroi supérieure formée par la face 423 en SiO2 de la couche d'encapsulation 40b. Elle comprend en outre une première face latérale 421 et une deuxième face latérale 422.

La cavité 42 présente de préférence une largeur ws entre les première et deuxième faces latérales 421, 422 de l'ordre de 3 µm, une longueur comprise entre 10 µm et 20 µm en fonction du nombre d'ouvertures 41 et une hauteur entre les parois inférieure et supérieure égale à la hauteur de la couche sacrificielle 30.

La largeur ws de la cavité 42 peut être avantageusement inférieure à la largeur w de la première ouverture, de sorte à former une première marche 31 entre le BOX 12 et la première zone de contact 1, et une deuxième marche 32 entre le BOX 12 et la deuxième zone de contact 2.

La longueur de la cavité 42 peut être inférieure à la longueur de la première ouverture, de sorte à former une troisième marche entre le BOX 12 et le guide d'onde 301.

La cavité 42 est de préférence centrée par rapport à la première ouverture, au moins selon y, de façon à obtenir des première et deuxième marches 31, 32 présentant une largeur identique.

En particulier, la première ouverture peut présenter une largeur w = 3,2 µm, la cavité 42 peut présenter une largeur ws comprise entre 3 et 3,18 µm, et les première, deuxième et troisième marches 31, 32 peuvent présenter une largeur supérieure ou égale à 10 nm et/ou inférieure ou égale à 100 nm.

La gravure est ici configurée pour produire des alvéoles et, par suite, la cavité 42 de forme et d'orientation contrôlées.

Selon z, les alvéoles s'étendent avantageusement sur toute la hauteur de la couche sacrificielle 30, entre une face inférieure 424 formée par une partie exposée du BOX 12 et une face supérieure 423 formée par une partie exposée de la couche d'encapsulation 40b.

Selon x et y, les alvéoles s'étendent de préférence selon une section sensiblement carrée dans le plan xy, les côtés du carré étant alignés selon x et y.

Dans le cas de la gravure de la couche sacrificielle 30 en Si, et plus généralement pour des matériaux présentant une structure cristallographique de type cubique faces centrées ou zinc blende, une telle forme carrée peut être avantageusement obtenue par une gravure anisotrope.

Une telle gravure anisotrope est notamment plus rapide dans les plans les plus denses du cristal.

Selon un mode de réalisation, la gravure, sèche ou humide, est configurée pour obtenir une vitesse de gravure dans les directions cristallographiques [110] et [1-10], supérieure d'au moins 25 %, et de préférence d'au moins 35 %, à la vitesse de gravure dans les directions [010] et [100].

Les directions des vitesses les plus grandes vont définir les diagonales d'un carré, aux tolérances de réalisation près. De ce fait, les côtés du carré sont orientés suivant la direction cristallographique [100] ou perpendiculairement à cette direction.

Les côtés de chaque alvéole selon x et y s'étendent donc préférentiellement respectivement selon les directions cristallographiques [100] et [010].

Dans le cas de la gravure de la couche sacrificielle 30 en Si, une gravure chimique utilisant un flux de vapeur d'acide chlorhydrique HCl à une température inférieure à 850°C, et de préférence inférieure à 820°C peut être avantageusement mise en oeuvre. La pression dans la chambre de gravure peut être comprise entre 10 Torr et la pression atmosphérique, et de préférence égale à 80 Torr. Le flux de HCl délivré peut être compris entre 1 slm et 25 slm (slm est l'acronyme de « standard liter per minute » en anglais, pour litres normaux par minute), et de préférence 15 slm. Un flux de H2 peut aussi être ajouté, par exemple entre quelques 1 slm et 40 slm de préférence 20 slm.

Ces conditions de gravure permettent de préférence de limiter le régime de gravure par réaction de surface, de façon à produire une gravure anisotrope de la couche sacrificielle 30 en Si.

Suivant une autre possibilité, la gravure est une gravure humide au travers des ouvertures 41. Dans le cas de la gravure de la couche sacrificielle 30 en Si, une solution de préférence aqueuse et comprenant de l'hydroxyde de potassium peut être utilisée. La gravure humide, appliquée à un espace confiné, permet d'obtenir des vitesses de gravure différentes selon les directions cristallographiques.

Lors de la gravure, les première et deuxième parois latérales sensiblement parallèles au plan zx de chacune des alvéoles progressent respectivement en direction des première et deuxième zones de contact 1, 2, tandis que les troisième et/ou quatrième parois latérales sensiblement parallèles au plan zy de deux alvéoles adjacentes progressent les unes vers les autres.

Le temps de gravure est de préférence choisi de manière à ce que les alvéoles issues de chaque ouverture 41 se rejoignent entre elles selon y de sorte à former la cavité 42 en fin de gravure.

Ces alvéoles préservent avantageusement le matériau, ici le silicium, de la couche sacrificielle 30 au moins sur les parois sensiblement parallèles au plan zx, de sorte à former les première et deuxième faces latérales 421, 422 de la cavité 42.

La gravure est de préférence configurée pour que ces première et deuxième faces latérales 421, 422 selon zx de la cavité 42 forment respectivement les contremarches des première et deuxième marches 31, 32 des première et deuxième zones de contact 1, 2.

La gravure de la couche sacrificielle 30 et la définition du guide d'onde 301 sont de préférence configurées de manière à ce que le flanc 421 soit situé dans le prolongement du flanc longitudinal 311 du guide d'onde 301, afin d'optimiser le couplage optique entre le guide d'onde 301 et la zone d'absorption ultérieurement formée.

Selon une possibilité alternative, la gravure peut être arrêtée lorsque les première et deuxième faces latérales 421, 422 selon zx de la cavité 42 se trouvent sensiblement à l'aplomb des première et deuxième faces latérales 411, 412 selon zx de la première ouverture, c'est-à-dire pour une largeur ws sensiblement égale à la largeur w.

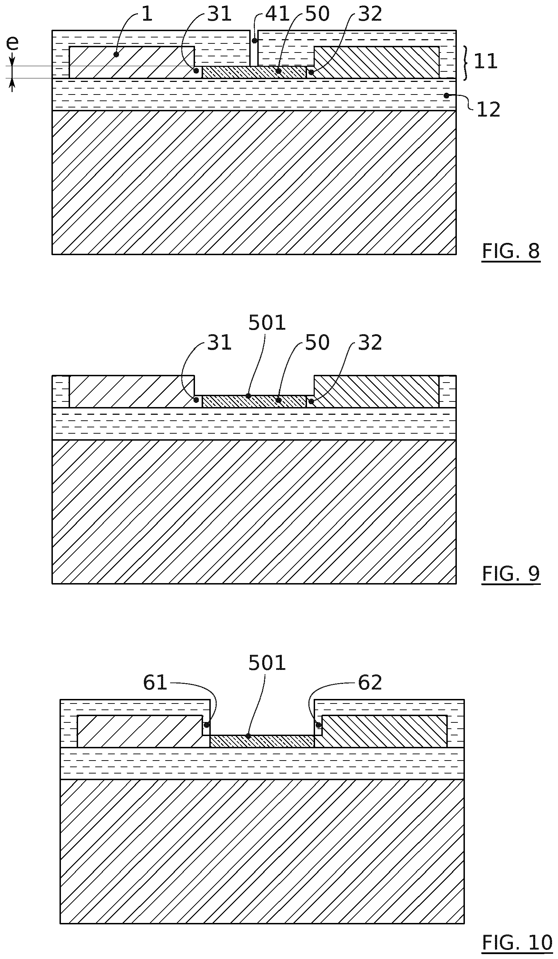

La cavité 42 est ensuite avantageusement remplie par épitaxie latérale de germanium ou d'un alliage à base de germanium, par exemple du GeSn, de sorte à former la couche de base 50 (figure 8).

Dans la suite, des croissances épitaxiales de Ge sont décrites. L'invention s'applique également mutatis mutandis à des croissances épitaxiales de GeSn.

Le germanium est avantageusement épitaxié sur les parois latérales 421, 422 à base de silicium de la cavité 42 par une première croissance épitaxiale latérale.

Cette croissance par épitaxie latérale est guidée par les parois inférieure et supérieure à base de SiO2 de la cavité 42.

Le front de croissance issu de la première paroi latérale 421 se propage donc selon y en direction de la deuxième zone de contact 2 de façon bien contrôlée. De façon similaire, le front de croissance issu de la deuxième paroi latérale 422 se propage selon y en direction de la première zone de contact 1 de façon bien contrôlée.

Les fronts de croissance se rejoignent dans une zone médiane sensiblement à l'aplomb des ouvertures 41.

La couche de base 50 ainsi formée présente une épaisseur égale à l'épaisseur résiduelle e, comprise entre 10 nm et 50 nm.

Une telle épaisseur permet de limiter l'apparition de défauts structuraux dans la couche de base 50. En particulier, la croissance peut être pseudomorphe, c'est-à-dire que les contraintes d'épitaxie (liées notamment à la différence de paramètres de maille entre le Si et le Ge) peuvent être relâchées élastiquement pendant la croissance.

La qualité cristalline de cette couche de base 50 en Ge peut ainsi être optimisée.

La figure 17 montre une couche de Ge accolée latéralement à une couche de Si. Cette couche de Ge présente une épaisseur de 16 nm, et a été obtenue par épitaxie latérale entre deux couches d'oxyde formant les parois inférieure et supérieure selon l'invention.

La couche de Ge ainsi obtenue est exempte de défauts structuraux. En particulier, elle est exempte de dislocations, notamment de dislocations traversantes.

Par ailleurs, l'interface entre la couche de Si et la couche de Ge est plane et bien définie.

L'épitaxie latérale du germanium est de préférence réalisée à partir d'une chimie basée sur un précurseur germane GeH₄ ou digermane Ge₂H₆ en phase gazeuse. Un ajout d'acide chlorhydrique HCl en phase gazeuse peut avantageusement permettre d'éviter un trop fort encrassement des parois de la chambre du bâti d'épitaxie lors de l'épitaxie.

Cette épitaxie latérale de germanium est de préférence effectuée à une température « basse » de l'ordre de 300°C à 400°C et à une pression de l'ordre de 100 Torr pendant une durée comprise entre 5 min et 15 min. Une telle température « basse » permet également de limiter l'apparition de défauts d'épitaxie dans la couche de base 50.

Selon une possibilité, l'épitaxie latérale de germanium peut se faire en deux temps, d'abord à la température « basse » puis à une température « haute » de l'ordre de 600°C à 700°C et à une pression de l'ordre de 20 Torr pendant une durée comprise entre 5 min et 60 min. Une telle température « haute » permet de bénéficier de vitesses de croissance élevées compatibles avec un remplissage d'une cavité 42 de grandes dimensions. Une telle température « haute » permet également de répartir plus uniformément les dislocations présentes au sein du germanium épitaxié grâce à une plus grande mobilité desdites dislocations, et de minimiser potentiellement leur densité par recombinaison/annihilation de dislocations.

L'épitaxie latérale de germanium est poursuivie jusqu'à ce que le germanium couvre toute la face inférieure 424 en SiO2 du BOX 12.

Elle peut être poursuivie jusqu'à ce que le germanium remplisse au moins partiellement les ouvertures 41.

La couche de base ainsi formée assure une continuité électrique entre les première et deuxième marches 31, 32.

Après remplissage de la cavité 42 par épitaxie latérale du germanium, une étape de cyclage thermique optionnelle, sous H₂ à des températures variant entre 750°C et 890°C sur des cycles courts de quelques minutes peut avantageusement permettre de réduire la densité de dislocations dans le germanium.

Les couches d'encapsulation 40a, 40b sont ensuite retirées, au moins partiellement, de manière à exposer la face supérieure 501 de la couche de base 50 (figure 9). Une gravure humide du SiO2 sélectivement au Si et au Ge peut être mise en oeuvre de façon à retirer ces couches d'encapsulation 40a, 40b. Une telle gravure est largement connue de l'homme du métier.

De façon optionnelle, une étape de planarisation comprenant par exemple une gravure anisotrope de la couche de base 50 peut être effectuée de sorte à retirer une excroissance du germanium au niveau des ouvertures 41.

Cette étape de planarisation est configurée de manière à améliorer la planéité de la face supérieure 501 de la couche de base 50.

Une autre étape de préparation de surface, par exemple un nettoyage, de la face supérieure 501 peut également être effectuée, préalablement à la deuxième croissance épitaxiale verticale de Ge.

Une étape de masquage des faces à base de Si peut être avantageusement effectuée, de sorte à exposer uniquement la face supérieure 501 de la couche de base 50 en Ge (figure 10).

Les première et deuxième zones de contact 1, 2, les première, deuxième et troisième marches 31, 32, et/ou les flancs de la première ouverture peuvent ainsi être couverts par une couche en un matériau diélectrique, par exemple du SiO2 ou un nitrure de silicium (SiN) peu contraint.

Des couches latérales 61, 62 en SiO2 ou en SiN sont ainsi avantageusement formées.

La première couche latérale 61 couvrant la première face latérale 411 peut présenter une largeur w1 comprise entre 10 nm et 100 nm.

La deuxième couche latérale 62 couvrant la deuxième face latérale 412 peut présenter une largeur w2 comprise entre 10 nm et 100 nm.

Une troisième couche latérale couvrant la face de sortie du guide d'onde 301 peut présenter une dimension selon x comprise entre 10 nm et 100 nm.

Idéalement, la première couche latérale 61 et/ou la deuxième couche latérale 62 présentent la même largeur que, respectivement, la première marche 31 et/ou la deuxième marche 32, telle que w1 = (w - ws)/2 et/ou w2 = (w - ws)/2.

Le flanc latéral libre de la première couche latérale 61 est dès lors de préférence à l'aplomb du flanc 421. Le flanc latéral libre de la deuxième couche latérale 62 est dès lors de préférence à l'aplomb du flanc 422.

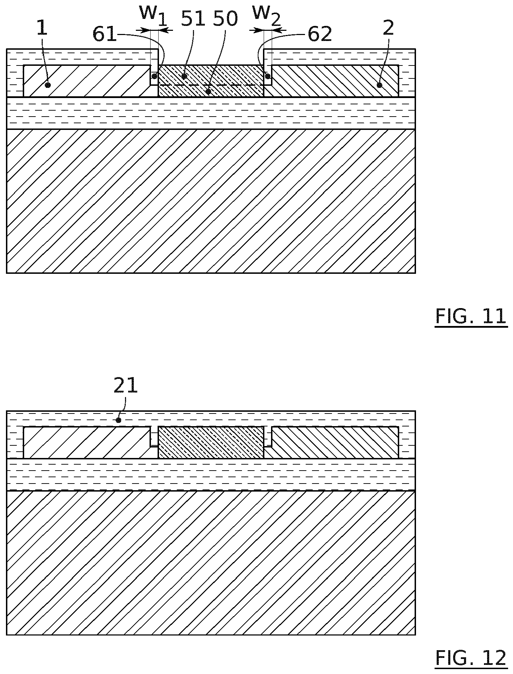

Ces première, deuxième et troisième couches latérales 61, 62 permettent avantageusement de guider la deuxième croissance épitaxiale verticale de Ge (figure 11).

Les première et deuxième couches latérales 61, 62 sont de préférence en un matériau à bas indice de réfraction. Elles permettent ainsi d'améliorer le confinement optique d'une onde lumineuse dans la zone d'absorption A. Ces première et deuxième couches latérales 61, 62 reposant sur les première et deuxième marches 31, 32 induisent à la fois un confinement optique par contraste d'indices de réfraction, et un confinement optique géométrique.

En particulier, des première et deuxième couches latérales 61, 62 en SiO2 présentent une grande différence d'indice de réfraction avec le Ge de la zone d'absorption A. Cela augmente le confinement optique dit par contraste d'indices.

Les première et deuxième marches 31, 32 forment dans le plan zy un profil transverse « en arête ». Cela augmente le confinement optique géométrique.

La troisième couche latérale est de préférence configurée pour optimiser le couplage optique entre le guide d'onde 301 et le Ge de la zone d'absorption A, c'est-à-dire pour optimiser la transmission d'une onde lumineuse se propageant depuis le guide d'onde vers la zone d'absorption A selon un mode optique donné.

En particulier, pour une dimension selon x inférieure ou égale à 20 nm, une troisième couche latérale en SiO2 permet de transmettre un mode gaussien d'une onde lumineuse présentant une longueur d'onde de l'ordre de 1,55 µm quasiment sans pertes optiques. Pour une dimension selon x supérieure ou égale à 40 nm, une troisième couche latérale en SiN peu contraint, présentant un indice de réfraction supérieur au SiO2, permet de limiter les pertes optiques dans la transmission d'un mode gaussien d'une onde lumineuse présentant une longueur d'onde de l'ordre de 1,55 µm.

La deuxième croissance par épitaxie verticale du Ge se fait à partir de la face supérieure 501 de la couche de base 50. Cette couche de base 50 forme donc un germe ou une couche de germination pour la croissance de la couche de structure 51.

Les couches latérales 61, 62 évitent une croissance parasite de Ge sur les flancs de la première ouverture et, de préférence, sur les marches 31, 32.

Le front de croissance issu de cette face supérieure 501 se propage donc selon z de façon bien contrôlée.

La couche de structure 51 ainsi formée présente une qualité cristalline optimisée.

A l'issue de l'épitaxie verticale, le front de croissance correspond à la surface supérieure de la couche de structure 51.

Cette surface supérieure peut se situer soit en-dessous d'un plan comprenant les surfaces des zones de contact 1, 2, soit sensiblement dans ce plan, en affleurement des surfaces des zones de contact 1, 2, soit au-dessus de ce plan, en dépassement des surfaces des zones de contact 1, 2.

Dans ce dernier cas, un polissage ultérieur peut être effectué pour niveler les surfaces des zones de contact 1, 2 et la surface supérieure de la couche de structure 51. Ce nivellement est cependant optionnel.

L'épitaxie verticale du germanium est de préférence réalisée à partir d'une chimie basée sur un précurseur germane GeH₄ ou digermane Ge₂H₆ en phase gazeuse. Un ajout d'acide chlorhydrique HCl en phase gazeuse peut avantageusement permettre d'éviter un trop fort encrassement des parois de la chambre du bâti d'épitaxie lors de l'épitaxie.

Cette épitaxie verticale de germanium est de préférence effectuée à la température « haute » évoquée plus haut pour l'épitaxie latérale, de l'ordre de 600°C à 700°C, de sorte à bénéficier de vitesses de croissance élevées compatibles avec un remplissage d'une première ouverture de grandes dimensions.

Selon une possibilité, l'épitaxie verticale peut se faire en deux temps comme pour l'épitaxie latérale, d'abord à la température « basse » évoquée plus haut, de l'ordre de 300°C à 400°C, puis à la température « haute ».

La gravure du top Si 11 pour former la première ouverture et la cavité 42, et les première et deuxième croissances épitaxiales de germanium peuvent se faire avantageusement dans un même bâti, de sorte à éviter une oxydation des faces latérales 421, 422 et supérieure 501.

Une étape de planarisation comprenant par exemple un dépôt d'un matériau diélectrique, de préférence du SiO2, et un polissage mécano-chimique (CMP) est effectuée après la deuxième croissance, de sorte à obtenir une couche d'encapsulation 21 (figure 12).

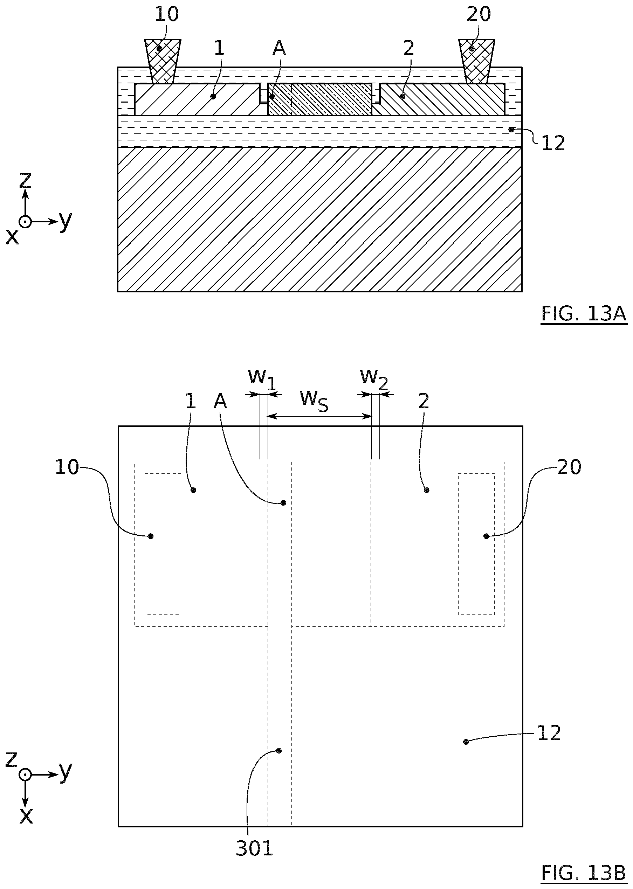

Les étapes suivantes peuvent être des étapes classiques de formation des contacts métalliques, comprenant notamment la formation de vias traversants au niveau des première et deuxième zones de contact 1, 2 (figure 13A), le dépôt des contacts métalliques 10, 20 dans les vias et d'éventuels recuits thermiques rapides (RTA de l'acronyme anglais « Rapid Thermal Annealing ») pour l'activation des contacts 10, 20.

Une photodiode latérale p-i-n GeOI à double hétérojonction est ainsi avantageusement obtenue (figures 13A et 13B).

Les première et deuxième marches 31, 32 de cette photodiode constituent des zones d'injection de porteurs. Pour compenser une faible épaisseur de ces zones d'injection de porteurs, le dopage des première et deuxième marches 31, 32 peut être augmenté, par exemple par une étape d'implantation à une dose plus élevée après avoir exposé la couche sacrificielle 30. Une dose supérieure ou égale à 5.10¹⁹ cm⁻³ peut convenir.

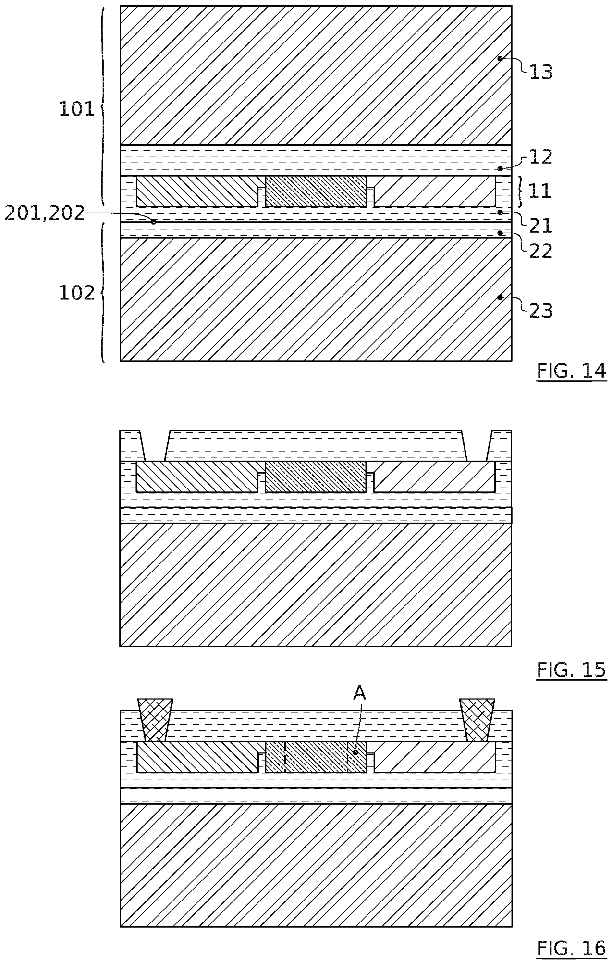

Un deuxième mode de réalisation du procédé selon l'invention va maintenant être décrit en référence aux figures 14 à 16. La photodiode obtenue par ce deuxième mode de réalisation est une photodiode p-i-n latérale à double hétérojonction issue d'un premier substrat 101 et reportée sur un deuxième substrat 102.

Seules les caractéristiques distinctes du premier mode de réalisation sont décrites ci-après, les autres caractéristiques non décrites étant réputées identiques à celles du premier mode de réalisation décrit ci-dessus en référence aux figures 2 à 13B.

Dans ce deuxième mode de réalisation, le premier substrat 101 est de préférence un substrat SOI.

Les premières étapes de ce deuxième mode de réalisation sont des étapes communes avec celles du premier mode de réalisation illustrées aux figures 4 à 12. Elles consistent essentiellement à former les première et deuxième zones de contact 1, 2, définir les premier et deuxième motifs 301, 302, former la première ouverture puis la cavité 42, faire les première et deuxième croissances de germanium et encapsuler le tout.

Ces étapes sont de préférence réalisées selon les mêmes conditions que celles exposées précédemment dans le premier mode de réalisation de l'invention.

Dans ce deuxième mode de réalisation, l'étape de planarisation permettant de former la couche d'encapsulation 21 comprend un dépôt d'oxyde SiO2, par exemple un dépôt CVD à partir d'un précurseur TEOS (« tetraethylorthosilicate » en anglais, ou orthosilicate de tétraéthyle), de façon à couvrir au moins le germanium de la couche de structure.

La couche d'encapsulation 21 est une couche d'oxyde 21. Cette couche d'oxyde 21 présente de préférence une épaisseur uniforme, comprise entre quelques dizaines de nanomètres et quelques centaines de nanomètres, et une face libre 201.

Le deuxième substrat 102 peut être par exemple un substrat de silicium 23 comprenant éventuellement des dispositifs optoélectroniques ou microélectroniques sur une face dite face active. Ce deuxième substrat 102 peut également comprendre des matériaux III-V et/ou des dispositifs de type photonique sur silicium sur sa face active.

Un dépôt d'oxyde, par exemple par CVD à partir d'un précurseur TEOS ou par oxydation thermique, peut être réalisé sur la face active du deuxième substrat 102 de sorte à former une couche d'oxyde 22 d'épaisseur comprise entre quelques centaines de nanomètres et quelques microns.

La somme des épaisseurs de la couche d'oxyde 21 et de la couche d'oxyde 22 est de préférence comprise entre 800 nm et 900 nm.

La couche d'oxyde 22 présente une face libre 202.

Un collage direct entre les premier et deuxième substrats 101, 102 est de préférence effectué.

Une étape de préparation de surface des faces libres 201, 202 des premier et deuxième substrats 101, 102, comprenant par exemple un nettoyage et une hydrolyse, est de préférence réalisée. Le nettoyage peut être réalisé par exemple dans un bain d'eau désionisée enrichie en ozone. L'hydrolyse peut être réalisée par exemple dans une solution de peroxyde d'ammonium (APM pour l'acronyme anglais « Ammonium peroxide mixture ») à 70°C.

Après préparation des surfaces, la face libre 201 de l'oxyde 21 du premier substrat 101 est mise en contact avec la face libre 202 de l'oxyde 22 du deuxième substrat 102, à température et pression ambiantes.

Un recuit à 400°C pendant deux heures peut ensuite être effectué de manière à finaliser le collage direct par adhésion moléculaire entre les oxydes 21, 22 (figure 14).

Le Si bulk 13 du premier substrat 101 peut ensuite être retiré, par exemple par rognage et abrasion sur au moins 95 % de son épaisseur initiale puis par gravure sélective dans une solution à base d'hydroxyde de tetramethylammonium (TMAH), de sorte à exposer le BOX 12. Une telle gravure peut présenter un ratio de sélectivité Si/SiO2 de l'ordre de 5000/1.

Cette possibilité permet d'obtenir en surface une couche d'oxyde d'épaisseur très bien contrôlée formée par le BOX 12 exposé. Certains composants photoniques nécessitant une telle couche d'oxyde d'épaisseur très bien contrôlée peuvent dès lors être formés sur le BOX 12 exposé. Par exemple, un modulateur capacitif comprenant des électrodes de part et d'autre du BOX 12 d'épaisseur très bien contrôlée peut avantageusement être formé. Un tel modulateur peut en effet présenter une précision améliorée sur les valeurs de la capacité. Son fonctionnement peut ainsi être avantageusement optimisé.

Des vias traversants au niveau des première et deuxième zones de contact 1, 2 de la photodiode peuvent ensuite être formés (figure 15), et des contacts métalliques 10, 20 peuvent ensuite être déposés au niveau des vias puis activés (figure 16).

Avantageusement, les contacts métalliques 10, 20 présentent des surfaces métalliques en affleurement des première et deuxième zones de contact 1, 2, dans un plan définissant une bordure supérieure de la zone d'absorption A. Le transport de charges et/ou le confinement optique d'une telle photodiode p-i-n latérale est amélioré par rapport à une solution nécessitant de graver des vias au travers d'une couche de germination 111.

Une photodiode p-i-n latérale GeOI à double hétérojonction reportée sur un deuxième substrat 102 peut ainsi être réalisée (figure 16).

Une puce comprenant au moins une photodiode p-i-n latérale GeOI à double hétérojonction sur une première face du BOX 12, et par exemple au moins un modulateur capacitif en partie sur une deuxième face du BOX 12 opposée à la première face peut ainsi être avantageusement obtenue.

Le procédé selon l'invention permet d'obtenir des photodiodes latérales p-i-n GeOI. De telles photodiodes constituent également un aspect séparable de l'invention.

L'invention n'est pas limitée aux modes de réalisations précédemment décrits et s'étend à tous les modes de réalisation couverts par les revendications.

## Revendications

1. Procédé de réalisation d'une photodiode comprenant une première zone de contact (1), une deuxième zone de contact (2) et une zone d'absorption (A) juxtaposées parallèlement à une première direction (x) d'un plan basal, ladite zone d'absorption (A) étant située entre les première et deuxième zones de contact (1, 2) selon une deuxième direction (y) du plan basal, ledit procédé comprenant les étapes suivantes :
- Fournir un premier substrat (101) comprenant un empilement selon une troisième direction (z) normale au plan basal d'une première couche (11) à base d'un premier matériau sur une deuxième couche (12) à base d'un deuxième matériau différant du premier matériau,
- Former au niveau de la première couche (11) la première zone de contact (1),
- Former au niveau de la première couche (11) la deuxième zone de contact (2),
- Former au niveau de la première couche (11) la zone d'absorption (A),
ledit procédé étant **caractérisé en ce que** la zone d'absorption (A) est formée par au moins une première croissance d'une couche de base, dite croissance latérale, suivie d'au moins une deuxième croissance d'une couche de structure, dite croissance verticale, la première croissance comprenant les étapes successives suivantes :
- Retirer le premier matériau dans la zone d'absorption sur toute l'épaisseur de la première couche de façon à exposer une face inférieure (424) à base du deuxième matériau, et au moins une face à base du premier matériau sensiblement normale au plan basal, dite face latérale (421), présentant un bord au contact de ladite face inférieure (424) exposée,
- Former la couche de base (50) en un troisième matériau par croissance épitaxiale dudit troisième matériau à partir de l'au moins une face latérale, ladite croissance étant principalement dirigée selon la deuxième direction et au moins partiellement guidée par au moins une paroi parallèle au plan basal, de sorte que la couche de base (50) couvre toute la face inférieure (424),
et la deuxième croissance comprenant les étapes successives suivantes :
- Exposer une face supérieure (501) de la couche de base (50) parallèle au plan basal,
- Former la couche de structure (51) en un quatrième matériau par croissance épitaxiale dudit quatrième matériau selon la troisième direction à partir de la face supérieure (501) de la couche de base (50).

2. Procédé selon la revendication précédente, dans lequel la première croissance comprend les sous-étapes suivantes pour retirer le premier matériau sur toute l'épaisseur de la première couche :
- Retirer le premier matériau de la première couche en conservant une couche sacrificielle (30) à base du premier matériau sur la deuxième couche, ladite couche sacrificielle présentant une épaisseur résiduelle e selon la troisième direction et une largeur w selon la deuxième direction,
- Encapsuler la couche sacrificielle (30) par une couche d'encapsulation (40) en un matériau d'encapsulation différant du premier matériau,
- Former au moins une ouverture (41) au travers de la couche d'encapsulation (40) de sorte à exposer une zone de la couche sacrificielle,
- Former une cavité (42) de largeur ws telle que ws ≤ w en retirant le premier matériau sur toute l'épaisseur résiduelle de la couche sacrificielle (30) au travers de l'au moins une ouverture (41), de façon à exposer la face inférieure (424) à base du deuxième matériau, l'au moins une face latérale (421) et une face (423) de la couche d'encapsulation, la cavité (42) comprenant ladite au moins une face latérale (421), une paroi inférieure formée par ladite face inférieure (424) et une paroi supérieure parallèle au plan basal et à base du matériau d'encapsulation formée par ladite face (423) de la couche d'encapsulation (40),
de sorte que la croissance épitaxiale permettant de former la couche de base (50) soit au moins partiellement guidée par lesdites parois inférieure et supérieure, la couche de base (50) présentant une épaisseur égale à l'épaisseur résiduelle e.

3. Procédé selon l'une quelconque des revendications précédentes, dans lequel les premier, troisième et quatrième matériaux présentent chacun une structure cristallographique de type cubique, et dans lequel la première direction (x) correspond à une orientation cristallographique de type [100], la deuxième direction (y) correspond à une orientation cristallographique de type [010], et la troisième direction (z) correspond à une orientation cristallographique de type [001].

4. Procédé selon les revendications 2 et 3 en combinaison, dans lequel le retrait du premier matériau lors de la formation de la cavité (42) se fait par gravure, ladite gravure étant configurée pour produire une vitesse de gravure au moins 25 % plus grande dans des directions cristallographiques [110] et [1-10] que dans des directions cristallographiques [010] et [100] du premier matériau de la première couche (11), et de préférence au moins 35 % plus grande.

5. Procédé selon l'une quelconque des revendications précédentes, dans lequel la deuxième croissance comprend en outre, avant formation de la couche de structure, l'étape suivante :
- Former au moins une couche latérale (61, 62) présentant des parois latérales sensiblement normales au plan basal en un matériau différant du premier matériau, ladite au moins une couche latérale (61, 62) prenant appui sur une face parallèle au plan basal comprenant la face supérieure (501) de la couche de base (50),
de sorte que la croissance épitaxiale permettant de former la couche de structure (51) soit au moins partiellement guidée par lesdites parois latérales.

6. Procédé selon les revendications 2 et 5 en combinaison, dans lequel la deuxième croissance comprend les sous-étapes suivantes pour former l'au moins une couche latérale :
- Retirer partiellement la couche d'encapsulation (40) de façon à exposer la face parallèle au plan basal comprenant la face supérieure (501) de la couche de base (50), en laissant une partie du matériau d'encapsulation de façon à former l'au moins une couche latérale (61, 62).

7. Procédé selon les revendications 2 et 5 en combinaison dans lequel la deuxième croissance verticale comprend les sous-étapes suivantes pour former l'au moins une couche latérale (61, 62) :
- Retirer totalement la couche d'encapsulation (40) de façon à exposer la face parallèle au plan basal comprenant la face supérieure (501) de la couche de base (50),
- Former l'au moins une couche latérale (61, 62) en un matériau pris parmi un oxyde de silicium et un nitrure de silicium.

8. Procédé selon la revendication 2 seule ou en combinaison avec l'une quelconque des revendications 3 à 7, dans lequel la largeur ws de la cavité (42) est strictement inférieure à la largeur w de la couche sacrificielle (30), de préférence w - ws ≥ 125 nm, de sorte que la couche sacrificielle (30) forme au moins une marche (31) entre la deuxième couche (12) et la première couche (11).

9. Procédé selon la revendication 5 seule ou en combinaison avec l'une quelconque des revendications 6 ou 7 dans lequel l'au moins une couche latérale (61, 62) comprend une première couche latérale (61) au contact d'au moins une face de la première zone de contact sensiblement normale à la deuxième direction, ladite première couche latérale présentant une largeur w1 selon la deuxième direction supérieure ou égale à 10 nm et/ou inférieure ou égale à 100 nm.

10. Procédé selon l'une quelconque des revendications précédentes dans lequel la couche de base (50) présente une épaisseur e selon la troisième direction supérieure ou égale à 10 nm et/ou inférieure ou égale à 50 nm.

11. Procédé selon la revendication 2 seule ou en combinaison avec l'une quelconque des revendications 3 à 13 dans lequel l'au moins une ouverture (41) présente un contour fermé et est distante de la première zone de contact (1) d'une distance d selon la deuxième direction (y) telle que 0.6 µm < d < 1.5 µm et de préférence 1.1 µm < d < 1.5 µm.

12. Procédé selon l'une quelconque des revendications précédentes dans lequel le premier substrat (101) comprend une troisième couche (13), de sorte que la deuxième couche (12) soit intercalée entre les première et troisième couches (11, 13) selon la troisième direction (z), le procédé comprenant en outre une séquence d'étapes de retournement de la photodiode sur un deuxième substrat (102), ladite séquence comprenant les étapes suivantes :
- Fournir un deuxième substrat (102),
- Coller par adhésion moléculaire le deuxième substrat (102) au premier substrat (101) selon la troisième direction (z), la première couche (11) du premier substrat (101) étant tournée en regard du deuxième substrat (102),
- Retirer la troisième couche (13) du premier substrat (101).
- Former au travers de la deuxième couche du premier substrat des premier et deuxième contacts métalliques respectivement sur les première et deuxième zones de contact.

13. Photodiode comprenant une première zone de contact (1), une deuxième zone de contact (2) et une zone d'absorption (A) formées dans une première couche (11) à base d'un premier matériau et juxtaposées de sorte à s'étendre parallèlement suivant une première direction (x), ladite zone d'absorption (A) étant située entre les première et deuxième zones de contact (1, 2) selon une deuxième direction (y), la première couche (11) étant au contact d'une deuxième couche (12) à base d'un deuxième matériau différant du premier matériau, selon une troisième direction (z) perpendiculaire aux première et deuxième directions (x, y), la photodiode étant **caractérisée en ce que** la zone d'absorption (A) est formée suivant une épaisseur de la première couche (11) et comprend au moins un troisième matériau (3) différant des premier et deuxième matériaux et directement au contact du deuxième matériau de la deuxième couche (12), et **en ce que** l'une au moins parmi les première et deuxième zones de contact (1, 2) présente une marche en regard de l'autre parmi les première et deuxième zones de contact (1, 2), ladite marche prenant appui sur la deuxième couche (12) et étant située entre la première couche (11) et la zone d'absorption (A).

14. Photodiode selon la revendication précédente dans laquelle la marche présente une épaisseur e selon la troisième direction supérieure ou égale à 10 nm et/ou inférieure ou égale à 50 nm.

15. Photodiode selon l'une quelconque des trois revendications précédentes comprenant en outre au moins une couche latérale prenant appui sur la marche et située entre la première couche (11) et la zone d'absorption (A), ladite au moins une couche latérale étant en un matériau pris parmi un oxyde de silicium et un nitrure de silicium.
